Europäisches Patentamt

European Patent Office

Office européen des brevets

(19)

(11) Veröffentlichungsnummer: **0 109 120**
**B1**

(12) **EUROPÄISCHE PATENTSCHRIFT**

(45) Veröffentlichungstag der Patentschrift:
02.09.87

(21) Anmeldenummer: **83201570.5**

(22) Anmeldetag: **02.11.83**

(51) Int. Cl.⁴: **H 01 L 41/02**

(54) Keramisches bistabiles Biegeelement.

(30) Priorität: **05.11.82 DE 3240684**

(43) Veröffentlichungstag der Anmeldung:
**23.05.84 Patentblatt 84/21**

(45) Bekanntmachung des Hinweises auf die Patenterteilung:
**02.09.87 Patentblatt 87/36**

(84) Benannte Vertragsstaaten:
**DE FR GB**

(56) Entgegenhaltungen:
**DE-A-2 918 625**
**DE-A-2 948 659**
**FR-A-2 411 533**

(73) Patentinhaber: **Philips Patentverwaltung GmbH,
Billstrasse 80, D-2000 Hamburg 28 (DE)**
(84) Benannte Vertragsstaaten: **DE**

(73) Patentinhaber: **N.V. Philips' Gloeilampenfabrieken,
Groenewoudseweg 1, NL- 5621 BA Eindhoven (NL)**
(84) Benannte Vertragsstaaten: **FR GB**

(72) Erfinder: **Schnell, Axel, Dr., Schlossweiherstrasse
39, D-5100 Aachen (DE)**

(74) Vertreter: **Nehmzow- David, Fritzi- Maria, Philips
Patentverwaltung GmbH Billstrasse 80 Postfach
10 51 49, D-2000 Hamburg 28 (DE)**

LIBER, STOCKHOLM 1987

## Beschreibung

Die Erfindung bezieht sich auf ein bistabiles Biegeelement mit zwei an ihren beiden Hauptflächen mit Elektroden versehenen Platten aus ferroelektrischer Keramik, die derart mit ihren Hauptflächen aufeinander angeordnet und fest miteinander verbunden sind, daß auch die inneren Elektroden elektrisch zugänglich sind.

Die Erfindung bezieht sich weiter auf ein Verfahren zur Herstellung eines solchen Biegeelementes.

Normalerweise werden einseitig eingespannte keramische Biegeelemente aus polarisierter, ferroelektrischer Keramik beim Anlegen einer Gleichspannung ausgelenkt, wobei die Auslenkung näherungsweise proportional zur angelegten elektrischen Spannung ist. Dies heißt, daß beim Abschalten der Spannung die Null-Position des Elementes auch weitgehend wieder erreicht wird. Ein solches Biegeelement mit zwei an ihren beiden Hauptflächen mit Elektroden versehenen Platten aus ferroelektrischer Keramik, die derart mit ihren Hauptflächen aufeinander angeordnet und fest miteinander verbunden sind, daß auch die inneren Elektroden elektrisch zugänglich sind, ist z. B. aus der DE-A 29 48 659 bekannt.

In manchen Fällen, z. B. wenn keramische Biegeelemente für Schaltzwecke eingesetzt werden sollen, kann es vorteilhaft sein, daß Schaltpositionen von dem keramischen Biegeelement nach Abschalten der elektrischen Spannung gehalten werden, d.h., die Auslenkung aufrecht erhalten bleibt, ohne daß eine weitere elektrische Spannung anliegen muß.

Mit der nationalen deutschen Patentanmeldung gemäß DE-A-32 12 576 ist ein tristabiler optischer Schalter in Form eines keramischen Biegeelementes mit zwei Platten aus ferroelektrischer Keramik vorgeschlagen worden, bei dem die Platten in der Ausgangsstellung des Schalters, d.h. in der "Null"-Stellung des Biegeelementes gleichmäßig depolarisiert sind und in der Schaltstellung jeweils eine Platte polarisiert ist. Dieser Schalter wird über eine abklingende Wechselspannung depolarisiert.

Dieser Schalter hat sich in der Praxis bewährt, nachteilig ist jedoch, daß die abklingende Wechselspannung nur unter einem gewissen technischen Aufwand zu erzeugen ist.

Der Erfindung liegt die Aufgabe zugrunde, ein keramisches Biegeelement zu schaffen, das geeignet ist, zwei stabile Positionen einzunehmen, ohne daß ständig eine elektrische Spannung anliegen muß, und das so eingerichtet und betreibbar ist, daß zur Depolarisation keine gesonderten apparativen Maßnahmen getroffen zu werden brauchen.

Diese Aufgabe wird erfindungsgemäß gelöst durch eine nach dem Verbinden mit der anderen Platte in einer der Platten erzeugten, im spannungslosen Zustand verbleibenden Polarisation, die eine Verbiegung des Biegeelements gemäß seinem ersten stabilen Zustand bewirkt, und durch elektrische Anschlüsse an den beiden äußeren Elektroden, über die beide Platten zur Umschaltung von dem ersten in einen zweiten stabilen Zustand in Serienschaltung mit einem Gleichspannungsimpuls ansteuerbar sind, dessen Polarität der der zur Polarisation der einen Platte verwendeten Spannung entgegengesetzt ist und der zu einer Polarisation der nicht polarisierten Platte sowie zu einer Depolarisation der polarisierten Platte führt.

Nach einer vorteilhaften Weiterbildung der Erfindung bestehen die Platten aus einer Mischkristall-Keramik auf Basis von Blei/Seltenerdmetall-Zirkonat/Titanat, insbesondere einer Zusammensetzung, die innerhalb des Systems Blei/Seltenerdmetall-Zirkonat/Titanat in der Nähe der morphotropen Phasengrenze auf der rhomboedrischen Seite liegt.

Ein Verfahren zur Herstellung eines derartigen keramischen Biegeelementes ist gekennzeichnet durch folgende Verfahrensschritte

a) zwei nicht polarisierte keramische Platten aus einer ferroelektrischen Keramik werden an ihren Hauptflächen mit Blektroden versehen;

b) die beiden Platten werden mit ihren Hauptflächen so aufeinander angeordnet und fest miteinander verbunden, daß die in der Mitte des auf diese Weise gebildeten Verbundkörpers liegenden Elektroden elektrisch zugänglich bleiben;

c) an den beiden äußeren Elektroden werden elektrische Anschlüsse angebracht;

d) über die gemeinsame, in der Mitte des Verbundkörpers liegende und über eine der äußeren Elektroden wird eine der Platten durch Anlegen eines elektrischen Gleichspannungsimpulses, der in der Platte eine oberhalb der Koerzitivfeldstärke der Keramik liegende Feldstärke erzeugt, polarisiert.

Die mit der Erfindung erzielbaren Vorteile bestehen insbesondere darin, daß das Biegeelement zwei stabile Lagen einnehmen kann, ohne daß zusätzliche apparative Maßnahmen getroffen werden müssen, um eine Depolarisation der jeweils polarisierten Platte des Biegeelementes herbeizuführen.

Der Erfindung liegt die Erkenntnis zugrunde, daß die Depolarisation der polarisierten Platte gleichzeitig mit der Polarisation der bis dahin nicht polarisierten Platte erfolgen kann, denn die Vertauschung des Polarisationszustandes kann einfach dadurch erfolgen, daß über die beiden äußeren Elektroden kurzzeitig eine Gleichspannung angelegt wird, die zur Polarisation der gerade nicht polarisierten Platte führt. Die bei diesem Polarisationsvorgang freiwerdenden Verschiebungsströme bewirken durch die Hintereinanderschaltung der beiden Platten, daß die andere Platte gerade genau depolarisiert ist. Dieser Vorgang ist beliebig wiederholbar. Ein weiterer Vorteil der Erfindung liegt darin, daß das Aufrechterhalten des Schaltzustandes praktisch leistungslos erfolgen kann, denn die zur Polarisation der ferroelektrischen keramischen Platten erforderliche Spannung muß nur kurzzeitig, d. h. kürzer als 1 sec lang angelegt werden, es handelt sich hier also um einen Spannungsimpuls. Die beim Polarisationsvorgang auftretenden hohen Längenänderungen können als Schaltvorgänge zum Umschalten eines Schalters verwendet werden. Diese genannten Längenänderungen sind immer größer als Längenänderungen von Elementen, bei denen der Polarisationszustand nicht geändert wird. Nach dem Umschalten kann die elektrische Spannung wieder abgeschaltet werden, wobei das Biegeelement in der ausgelenkten Stellung verbleibt.

Anhand der Zeichnung wird die Erfindung mit einem Ausführungsbeispiel beschrieben und in ihrer Wirkungsweise erläutert. Es zeigen:

Fig. 1 bis 3 Prinzipdarstellungen eines Biegeelementes gemäß der Erfindung in unterschiedlichen Positionen je nach Polarisationszustand der keramischen Platten,

Fig. 4 grafische Darstellung der Auslenkung eines Biegeelementes gemäß der Erfindung,

Fig. 5a und 5b Modell der Beeinflussung des Polarisationszustandes der beiden keramischen Platten des Biegeelementes gemäß der Erfindung durch Anlegen einer Gleichspannung an die äußeren Elektroden.

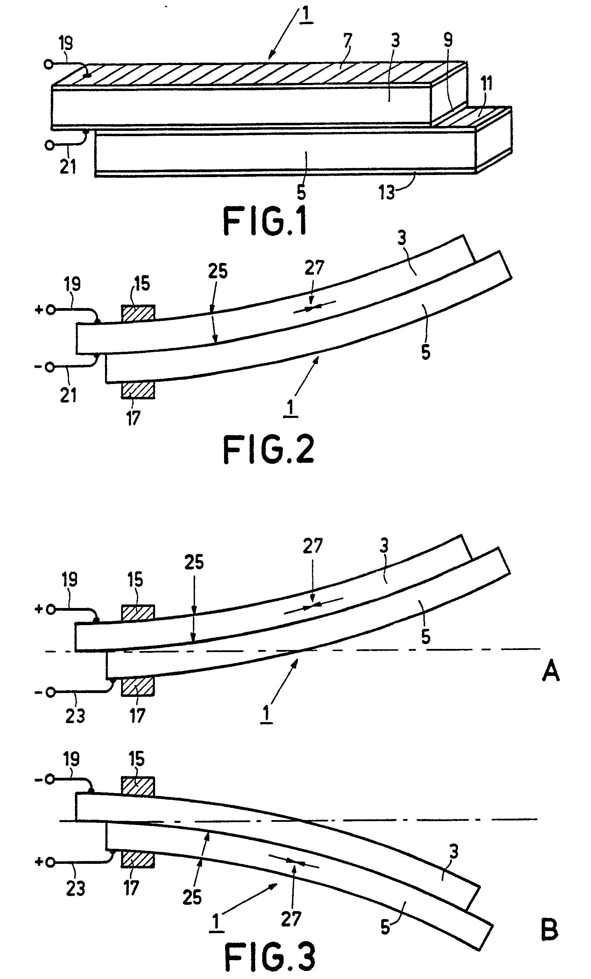

Ein Biegeelement 1 gemäß der Erfindung besteht aus zwei übereinander angeordneten Platten 3 und 5. Die Platten 3 und 5 sind fest miteinander verbunden, z. B. durch Verkleben, und an ihren Hauptflächen mit Elektroden 7, 9, 11 und 13 versehen. Diese Elektroden 7, 9, 11 und 13 sind der Einfachheit halber nur in Fig. 1 dargestellt, sie sollen jedoch auch als vorhanden gelten in den Prinzipdarstellungen gemäß Fig. 2 und 3. Die Elektroden 7 und 13 bilden die beiden äußeren Elektroden des Biegeelementes 1 mit seinen Platten 3 und 5. Die Platte 5 ist gegenüber der Platte 3 am Einspannende (Spannbacken 15 und 17) zurückversetzt, so daß die Elektroden 9 und 11 freiliegen und elektrisch zugänglich sind. An die Elektroden 7, 9 und 13 ist über jeweils zwei der Anschlüsse 19 und 21 oder 23 eine Spannungsquelle (nicht dargestellt) anschließbar. Die mit den nicht dargestellten Spannungsquellen erzeugte Polarität an den Anschlüssen ist mit "+" bzw. "-" dargestellt. Diese Polarität verursacht die Auslenkung des Biegeelementes.

Die Platten 3 und 5 des Biegeelementes 1 bestehen aus ferroelektrischer Keramik. Es handelt sich hierbei um eine leicht polarisierbare bzw. depolarisierbare Keramik auf Basis von Blei/Seltenerdmetall-Zirkonat/Titanat, insbesondere einer Zusammensetzung gemäß der Formel $Pb_{0,94} La_{0,06} Zr_{0,65} Ti_{0,35}O_3$. Die Koerzitivfeldstärke beträgt hierbei 7 kV/cm. Die Dicke der Platten 3 und 5 beträgt ca. 230 μm bei einer Länge von ca. 17 mm und einer Breite von ca. 7 mm. Die Elektroden 7, 9, 11 und 13 sind vorzugsweise aufgedampfte Elektrodenschichten.

Der neutrale Zustand der beiden Platten 3 und 5 ist in Fig. 1 dargestellt. In dieser Position sind die Platten 3 und 5 noch beide unpolarisiert und somit gleich lang, so daß sich eine geradlinige Ausrichtung der beiden Platten 3 und 5 ergibt. Nach Anlegen eines Gleichspannungsimpulses über die Anschlüsse 19 und 21 an die Platte 3 erfährt die Platte 3 durch Polarisation eine Längenänderung, und das Biegeelement erfährt eine Verbiegung, die auch nach Abschalten der Spannung erhalten bleibt (vergl. Fig. 2). Die Polarisationsrichtung ist in den Fig. 2 und 3 mit dem Pfeil 25 gekennzeichnet, die Richtung der Längenänderung mit den Pfeilen 27. Die Höhe des Spannungsimpulses zur Polarisation ist derart zu wählen, daß die von ihm erzeugte Feldstärke größer als die Koerzitivfeldstärke des zu polarisierenden Materials ist. Die Polarität des ersten Spannungsimpulses zur Polarisation ist unbeachtlich, da beim Polarisierungsvorgang immer eine Deformation gleicher Richtung zu beobachten ist. Das auf diese Weise vorbereitete Biegeelement ist jetzt gebrauchsfertig und befindet sich in einer von den beiden möglichen stabilen Positionen.

In Fig. 3a ist diese Position noch einmal als Position A dargestellt. Sie ist dadurch gekennzeichnet, daß die eine der beiden das Biegeelement 1 bildenden Platten 3 und 5, nämlich die Platte 5, unpolarisiert ist, während die andere Platte 3 elektrisch polarisiert ist.

Die andere der beiden möglichen stabilen Positionen, die Position B in Fig. 3, ist dadurch gekenzeichnet, daß der Polarisationszustand der Platten 3 und 5 gerade vertauscht ist, d. h., die zunächst nicht polarisierte Platte 5 ist nun polarisiert, und die anfänglich polarisierte Platte 3 wird bei dem Polarisationsprozeß für die Platte 5 depolarisiert. Diese Vertauschung des Polarisationszustandes erfolgt ohne jegliche zusätzliche Maßnahme schaltungstechnischer oder konstruktiver Art einfach dadurch, daß über die Anschlüsse 19 und 23 der beiden äußeren Elektroden 7 und 13 kurzzeitig eine Gleichspannung angelegt wird, die zur Polarisation der gerade nicht polarisierten Platte führt. Die bei diesem Polarisationsvorgang freiwerdenden Verschiebungsströme bewirken durch die Hintereinanderschaltung der beiden Platten 3 und 5, daß die polarisierte Platte gerade genau depolarisiert wird. Dieser Vorgang ist beliebig wiederholbar.

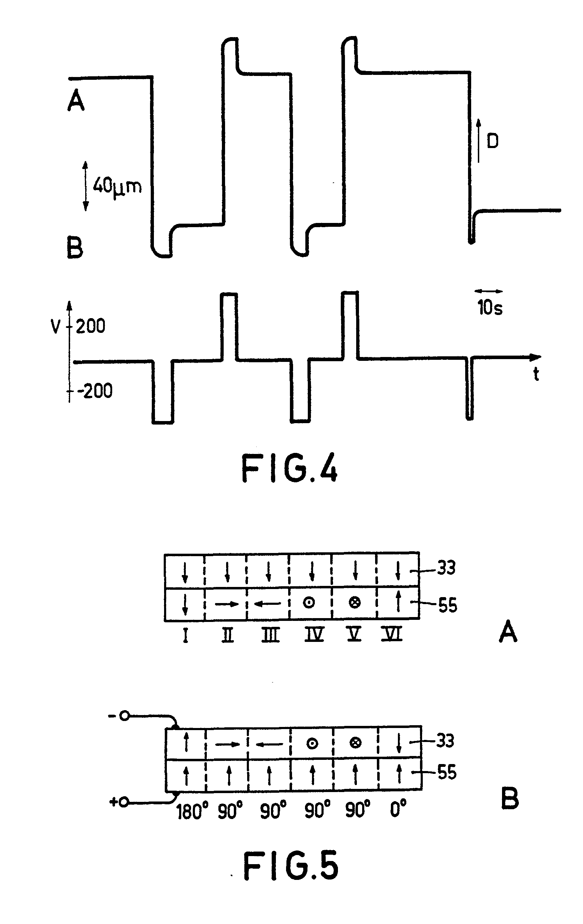

In Fig. 4 sind Meßergebnisse dargestellt, die mit einem Biegeelement gemäß der Erfindung gewonnen wurden. Die erzielbare Auslenkungen sind bei dem vorliegenden Biegeelement größer als bei einem keramischen Biegeelement gleicher Dimensionen, bei dem der Polarisationszustand nicht geändert, d. h. eine Auslenkung proportional zur angelegten Spannung erzielt wird.

Mit Fig. 5 wird als Modell gezeigt, daß bei der Vertauschung des Polarisationszustandes durch eine an die äußeren Elekroden angelegte Spannung die zunächst polarisierte Platte nur gerade genau bis zum Depolarisationszustand umgepolt werden kann. Fig. 5a zeigt, daß die nicht polarisierte Platte 55 dadurch gekennzeichnet ist, daß die Verteilung der Polarisationsrichtungen in der Keramik zwischen sämtlichen sechs Raumrichtungen (I... VI) gleichmäßig ist. Eine zu 100 % polarisierte Keramik zeigt demgegenüber nur eine einzige Polarisationsrichtung (Platte 33). Beim Umpolarisieren (Fig. 5b) kann durch den Verschiebungsstrom, der durch die Serienschaltung beider Platten 33, 55 in beiden Platten gleich groß ist, nur jeweils ein gleicher Anteil der Polarisation in beiden Platten geändert werden. Für die Raumrichtung I ist in beiden Platten 33, 55 eine Drehung der Polarisation um 180° möglich. Für die Raumrichtung II bis V ist jedoch nur jeweils eine Drehung um 90° möglich. Die Anteile der Raumrichtungen VI blockieren sich sogar gegenseitig, so daß hier keine Drehung möglich ist. Dadurch bleibt nach der Umpolarisation eine Gleichverteilung der Polarisationsrichtungen in der oberen, in Fig. 5b dargestellten Platte 33 übrig, d. h. das Material dieser Platte ist depolarisiert; das Material der Platte 55 ist vollständig polarisiert.

Die vorstehende Funktionsweise erfordert folgende Eigenschaften des Materials für die Platten 3 und 5 des Biegeelementes 1: Die Koerzitivfeldstärke soll möglichst niedrig sein, um mit möglichst niedrigen Spannungsimpulsen für die Polarisation bzw. Depolarisation der Keramik arbeiten zu können. Dabei soll der Unterschied zwischen der maximalen Längenänderung der keramischen Platten aufgrund der angelegten Spannung und der verbleibenden Längenänderung nach Abschalten des Spannungsimpulses möglichst gering sein.

Das beanspruchte keramische Biegeelement kann mit Vorteil als Schalter in Meßgeräten der optischen Nachrichtentechnik eingesetzt werden. Es kann aber ganz allgemein als Schaltelement überall da eingesetzt werden, wo magnetische Felder einen störenden Einfluß ausüben. Es kann z. B. Relais einsetzen, die, um störende magnetische Einflüsse auszuschalten, erst mit einer aufwendigen magnetischen Abschirmung versehen werden müssen.

**Patentansprüche**

1. Bistabiles Biegeelement mit zwei an ihren beiden Hauptflächen mit Elektroden versehenen Platten aus ferroelektrischer Keramik, die derart mit ihren Hauptflächen aufeinander angeordnet und fest miteinander verbunden sind, daß auch die inneren Elektroden elektrisch zugänglich sind, gekennzeichnet durch eine nach dem Verbinden mit der anderen Platte in einer der Platten erzeugten, im spannungslosen Zustand verbleibenden Polarisation, die eine Verbiegung des Biegeelements gemäß seinem ersten stabilen Zustand bewirkt, und durch elektrische Anschlüsse an den beiden äußeren Elektroden über die beide Platten zur Umschaltung von dem ersten in einen zweiten stabilen Zustand in Serienschaltung mit einem Gleichspannungsimpuls ansteuerbar sind, dessen Polarität der der zur Polarisation der einen Platte verwendeten Spannung entgegengesetzt ist und der zu einer Polarisation der nicht polarisierten Platte sowie zur Depolarisation der polarisierten Platte führt.

2. Biegeelement nach Anspuch 1, dadurch gekennzeichnet, daß die Platten aus einer Mischkristall-Keramik auf Basis von Blei/Seltenerdmetall-Zirkonat/Titanat bestehen.

3. Biegeelement nach Anspuch 2, dadurch gekennzeichnet, daß die Mischkristall-Keramik eine Zusammensetzung hat, die innerhalb des Systems Blei/Seltenerdmetall-Zirkonat/Titanat in der Nähe der morphotropen Phasengrenze auf der rhomboedrischen Seite liegt.

4. Biegeelement nach Anspuch 3, dadurch gekennzeichnet, daß die Mischkristall-Keramik eine Zusammensetzung gemäß der Formel $Pb_{0,94}La_{0,06}Zr_{0,65}Ti_{0,35}O_3$ hat.

5. Verfahren zur Herstellung eines Biegeelementes nach den Ansprüchen 1 bis 4, gekennzeichnet durch folgende Verfahrensschritte
a) zwei nicht polarisierte keramische Platten aus einer ferroelektrischen Keramik werden an ihren Haupflächen mit Elektroden versehen;
b) die beiden Platten werden mit ihren Hauptflächen so aufeinander angeordnet und fest miteinander verbunden, daß die in der Mitte des auf diese Weise gebildeten Verbundkörpers liegenden Elektroden elektrisch zugänglich bleiben;
c) an den beiden äußeren Elektroden werden elektrische Anschlüsse angebracht;
d) über die gemeinsame, in der Mitte des Verbundkörpers liegende und über eine der äußeren Elektroden wird das Material einer der Platten durch Anlegen eines elektrischen Gleichspannungsimpulses, der in der Platte eine oberhalb der Koerzitivfeldstärke der Keramik liegende Feldstärke erzeugt, polarisiert. 6. Verfahren nach Anspruch 5, dadurch gekennzeichnet, daß die Elektroden in Form von dünnen Schichten angebracht werden.

7. Verfahren nach Anspuch 6, dadurch gekennzeichnet, daß für die Platten eine Keramik auf Basis von Blei/Seltenerdmetall-Zirkonat/Titanat eingesetzt wird.

8. Verfahren nach Anspuch 7, dadurch gekennzeichnet, daß für die Platten eine Keramik mit einer Zusammensetzung innerhalb des Systems Blei/Seltenerdmetall-Zirkonat/Titanat in der Nähe der morphotropen Phasengrenze auf der rhomboedrischen Seite eingesetzt wird.

9. Verfahren nach Anspuch 7, dadurch gekennzeichnet, daß für die Platten eine Keramik mit einer Zusammensetzung gemäß der Formel $Pb_{0,94}La_{0,06}Zr_{0,65}Ti_{0,35}O_3$ eingesetzt wird.

## Claims

1. A bistable deflection element comprising two plates which are provided with electrodes on both their principal surfaces and which are made of a ferroelectric ceramic material, which plates are arranged with their principal surface one against the other and are rigidly interconnected so that the inner electrodes are also electrically accessible, characterized by a polarization in one of the plates produced after connection to the other plate, said polarization being sustained in the no-voltage condition and deflecting the deflection element to its first stable state, electrical connections being provided on the two external electrodes via which the two plates in series connection can be switched from the first to a second stable state by means of a direct voltage pulse whose polarity opposes that of the voltage used for the polarization of the one plate and which causes polarization of the non-polarized plate and depolarization of the polarized plate.

2. A deflection element as claimed in Claim 1, characterized in that the plates are made of a mixed crystal ceramic material on the basis of lead/rare earth metal-zirconate/titanate.

3. A deflection element as claimed in Claim 2, characterized in that the mixed crystal ceramic material has a composition which, within the system lead/rare earth metal-zirconate/titanate, is in the vicinity of the morphotropic phase limit on the rhombohedral side.

4. A deflection element as claimed in Claim 3, characterized in that the mixed crystal ceramic material has a composition in accordance with the formula $Pb_{0.94}La_{0.06}Zr_{0.65}Ti_{0.35}O_3$.

5. A method of manufacturing a deflection element as claimed in the Claims 1 to 4, characterized by the following steps:

a) two non-polarized ceramic plates of a ferroelectric ceramic material are provided with electrodes on their principal surfaces;

b) the two plates are arranged with their principal surfaces one against the other and are rigidly interconnected so that the electrodes which are situated in the centre of the assembly thus formed remain electrically accessible;

c) electrical connections are provided on the two external electrodes;

d) via the common electrodes which are situated in the centre of the assembly and via one of the external electrodes, the material of one of the plates is polarized by application of an electric direct voltage pulse which produces a field strength in the plate which exceeds the coercive field strength of the ceramic material.

6. A method as claimed in Claim 5, characterized in that the electrodes are provided in the form of thin layers.

7. A method as claimed in Claim 6, characterized in that a ceramic material on the basis of lead/rare earth metalzirconate-titanate is used for the plates.

8. A method as claimed in Claim 7, characterized in that a ceramic material having a composition which, within the system lead/rare earth metal-zirconate/titanate, is in the vicinity of the morphotropic phase limit on the rhombohedral side is used for the plates.

9. A method as claimed in Claim 7, characterized in that a ceramic material having a composition in accordance with the formula $Pb_{0.94}La_{0.06}Zr_{0.65}Ti_{0.35}O_3$ is used for the plates.

## Revendications

Elément de flexion bistable comportant deux plaques en céramique ferro-électrique qui sont munies d'électrodes sur leurs deux surfaces principales et qui sont superposées et réunies par leurs surfaces principales de façon que les électrodes intérieures sont également électriquement accessibles, caractérisé, d'une parti par une polarisation engendrée dans l'une des plaques après le raccordement à l'autre plaque et maintenue dans l'état hors tension, polarisation qui provoque une déformation de l'élément de flexion suivant son premier état stable et, d'autre part, par des connexions électriques prévues sur les deux électrodes extérieures et à travers lesquelles pour le passage du premier état stable au second état stable, les deux plaques, montées en série, peuvent être excitées au moyen d'une impulsion de tension continue dont la polarité est opposée à celle de la tension utilisée pour polariser l'une des plaques et qui provoque une polarisation de la plaque non polarisée ainsi qu'une dépolarisation de la plaque polarisée.

2. Elément de flexion selon la revendication 1, caractérisé en ce que les plaques sont constituées par une céramique à cristaux composites à base de plomb/métal des terres rares-zirconate/titanate.

3. Elément de flexion selon la revendication 2, caractérisé en ce que la céramique à cristaux composites a une composition qui, dans le système de plomb/métal des terres rares-zirconate/titanate, est située à proximité de la limite de phase morphotrope du côté rhomboédrique.

4. Elément de flexion selon la revendication 3, caractérisé en ce que la céramique à cristaux composites a une composition suivant la formule $Pb_{0.94}La_{0.06}Zr_{0.65}Ti_{0.35}O_3$.

5. Procédé de fabrication d'un élément de flexion selon l'une des revendications 1 à 4, caractérisé par les étapes suivantes:

a) deux plaques non polarisées en céramique ferro-électrique sont munies d'électrodes sur leurs surfaces principales;

b) les deux plaques sont superposées et rigidement réunies par leurs surfaces principales de façon que les électrodes situées au milieu de l'ensemble ainsi obtenu restent électriquement accessibles;

c) des connexions électriques sont prévues sur les deux électrodes extérieures;

d) à travers les électrodes communes situées au milieu de l'ensemble et à travers l'une des électrodes extérieures, l'une des plaques est polarisée par l'application d'une impulsion de tension continue qui engendre dans la plaque une intensité de champ supérieure à l'intensité de champ coercitive de la céramique.

6. Procédé selon la revendication 5, caractérisé en ce que les électrodes sont réalisées sous la forme de couches minces.

7. Procédé selon la revendication 6, caractérisé en ce qu'on utilise pour les plaques une céramique à base de plomb/métal des terres rares-zirconate/titanate.

8. Procédé selon la revendication 7, caractérisé en ce qu'on utilise pour les plaques une céramique ayant une composition qui, dans le système de plomb métal des terres rares-zirconate/titanate, est située à proximité de la limite de phase morphotrope du côté rhomboédrique.

9. Procédé selon la revendication 7, caractérisé en ce qu'on utilise pour les plaques une céramique ayant une composition suivant la formule $Pb_{0,94}La_{0,06}Zr_{0,65}Ti_{0,35}O_3$.

FIG.1

FIG.2

FIG.3

FIG.4

FIG.5